Europäisches Patentamt

European Patent Office

Office européen des brevets

(19)

(11) Numéro de publication : **0 447 276 B1**

(12) **FASCICULE DE BREVET EUROPEEN**

(45) Date de publication du fascicule du brevet :
**16.06.93 Bulletin 93/24**

(21) Numéro de dépôt : **91400334.8**

(22) Date de dépôt : **12.02.91**

(51) Int. Cl.$^5$ : **G11C 16/06,** G11C 8/00

(54) **Circuit mémoire avec élément de mémorisation de sélection de lignes de mots pour un effacement d'un bloc d'informations.**

(30) Priorité : **05.03.90 FR 9002736**

(43) Date de publication de la demande :
**18.09.91 Bulletin 91/38**

(45) Mention de la délivrance du brevet :
**16.06.93 Bulletin 93/24**

(84) Etats contractants désignés :
**DE FR GB IT**

(56) Documents cités :
**WO-A-83/01148
PATENT ABSTRACTS OF JAPAN, vol. 10, no. 30 (P-426)[2087], 5 février 1986; & JP-A-60 179 983**

(56) Documents cités :
**IBM TECHNICAL DISCLOSURE BULLETIN, vol. 27, no. 4B, septembre 1984, pages 2439-2441, New York, US; W.E. PROEBSTER et al.: "High-speed chip card reading"**

(73) Titulaire : **SGS-THOMSON MICROELECTRONICS S.A.
7, Avenue Galliéni
F-94250 Gentilly (FR)**

(72) Inventeur : **Silvestre de Ferron, Gérard
Cabinet Ballot-Schmit, 7, rue Le Seuer
F-75116 Paris (FR)**

(74) Mandataire : **Schmit, Christian Norbert Marie et al
Cabinet Ballot-Schmit 7, rue Le Sueur
F-75116 Paris (FR)**

Jouve, 18, rue Saint-Denis, 75001 PARIS

## Description

L'invention concerne une mémoire effaçable et programmable électriquement (EEPROM, flash EPROM) avec un mode d'effacement par bloc. Elle trouve son application dans les circuits mémoire et plus généralement dans tout circuit intégré comprenant de la mémoire.

On définit un tel mode d'effacement par bloc comme l'effacement simultané des cellules mémoire de plusieurs lignes de mot préalablement sélectionnées. Ces lignes de mot sélectionnées définissent un "bloc" d'informations mémorisées.

On rappelle que dans les mémoires effaçables et programmables, on trouve essentiellement trois technologies:

- les EPROM (erasable programmable memory) avec un effacement global de la mémoire par exposition aux rayons ultra-violets; on ne peut donc pas effacer une zone ou un bloc particulier de la mémoire.
- les EEPROM (electrically erasable programmable memory) avec effacement électrique séquentiel. Suivant l'organisation de la mémoire, par exemple en mots de 8 bits, on peut effacer un bloc d'information, séquentiellement, par effacement du mot d'une ligne de mot sélectionnée. Ainsi, pour effacer un bloc de 4 mots il faut sélectionner la 1ère ligne de mot : effacement de ses 8 cellules mémoire, puis la 2ème ligne de mot, ....puis la 4ème.
- les flash EPROM avec effacement électrique séquentiel global (de toute la mémoire). Elles existent aussi avec effacement électrique séquentiel par ligne de mot, comme les EEPROM.

Les EEPROM et flash EPROM permettent donc un effacement par bloc, mais séquentiellement : on efface successivement chaque ligne de mot. Ce mécanisme est donc très lent puisque pour un bloc de n lignes de mot, on a n sélections de ligne et n effacements, sachant par ailleurs que c'est l'opération d'effacement qui est déterminante dans le temps total nécessaire à l'effacement d'un bloc; par exemple la sélection d'une ligne demande 250ns et l'effacement de cette ligne demande 1s. On pourra se reporter à la demande WO-A8 301648

Dans la demande JP-A-60179983, une commande d'écriture multiple et un circuit porte permettent d'écrire une donnée à plusieurs adresses en même temps.

Le but de l'invention est de permettre l'effacement simultané de toutes les lignes d'un bloc quelconque à effacer d'une mémoire électriquement effaçable et programmable : on a ainsi une seule opération d'effacement, d'où une réduction radicale du temps d'effacement d'un bloc de la mémoire, par rapport aux techniques jusque-là utilisées pour les mémoires effaçables et programmables électriquement (EEPROM, flash EPROM).

De manière connue, les lignes de mot sont sélectionnées par décodage des lignes d'adresse de la mémoire. Supposons pour simplifier, que la mémoire ait une capacité de 4 octets (c'est à dire 4 mots de 8 bits). Il y a 4 lignes de mots à adresser LMO à LM3, ce qui nécessite deux lignes d'adresse a0, a1. Un circuit de décodage des deux lignes d'adresse, a donc en sortie les 4 lignes de mots LMO à LM3.

Si une sélection d'une ligne de mot se caractérise par un état bas sur cette ligne, on aura par exemple les équations logiques de décodage suivantes :

/LMO = /a0./a1
/LM1 = a0./a1
/LM2 = /a0.a1
/LM3 = a0.a1

Le tableau de fonctionnement correspondant est :

| a1 | a0 | sélection |
|----|----|-----------|
| 0 | 0 | LM0 |
| 0 | 1 | LM1 |
| 1 | 0 | LM2 |
| 1 | 1 | LM3 |

(le symbole "/" signifie le complément logique).

Ces équations sont aisées à mettre en oeuvre, par exemple à l'aide d'inverseurs et de portes NAND.

L'invention a pour objet de mémoriser la sélection des lignes de mot en introduisant entre les lignes d'adresse et les lignes de mot, un élément de mémorisation. Avantageusement, cette mémorisation pourra n'être validée que si la mémoire est dans un mode d'effacement par bloc.

L'invention a donc pour objet une mémoire électriquement programmable et effaçable comportant un décodeur de lignes de mot, le décodeur étant composé d'une première logique d'obtention des bits d'adresse des lignes de mot et de leurs compléments logiques et d'une deuxième logique de décodage des bits d'adresse et de leurs compléments logiques pour sélectionner une ligne de mot et délivrant des signaux de sélection, caractérisée en ce que le décodeur comporte en outre une logique de mémorisation d'adressage des lignes de mot, permettant une mémorisation de l'adressage de lignes de mot préalable à un effacement simultané des lignes de mot dont l'adressage a été mémorisé. L'invention a également pour objet un procédé d'effacement simultané d'un bloc d'informations dans une mémoire ci-dessus tel que défini dans la revendication 9.

D'autres caractéristiques et avantages de la présente invention seront mieux compris à la lecture de la description faite en référence aux figures annexées.

Cette description n'est qu'indicative et nullement limitative de l'invention.

Dans les figures annexées :
- la figure 1 est un schéma électrique d'un décodeur de ligne de mot avec un élément de mémorisation selon un premier mode de réalisation de l'invention;
- la figure 2 est un schéma électrique d'un décodeur de ligne de mot avec un élément de mémorisation selon un second mode de réalisation de l'invention;
- la figure 3 est un diagramme des temps des signaux mis en oeuvre pour un effacement par bloc selon le premier mode de l'invention.

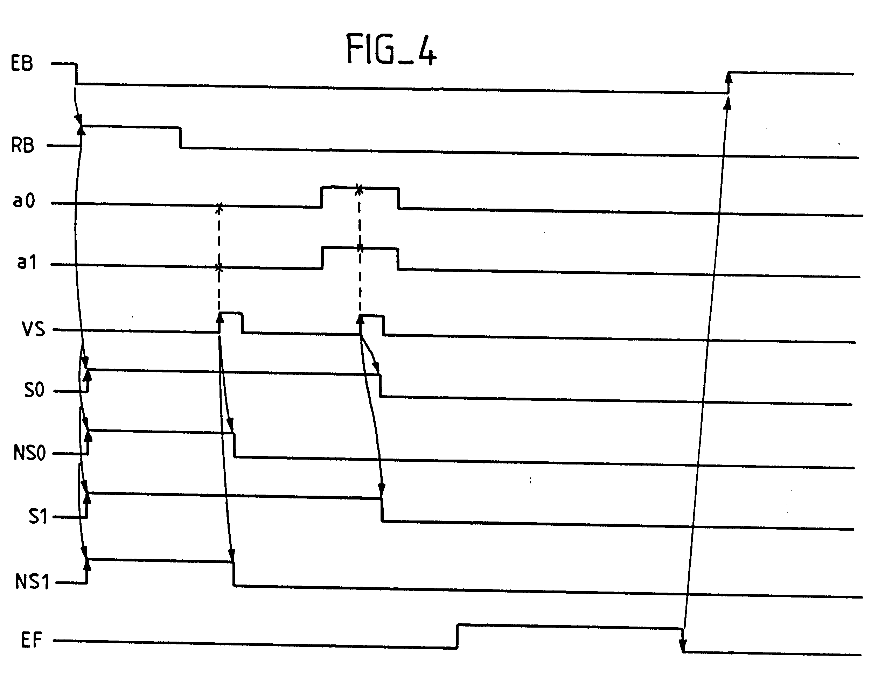

- la figure 4 est un diagramme des temps des signaux mise en oeuvre pour un effacement par bloc selon le second mode de réalisation de l'invention.

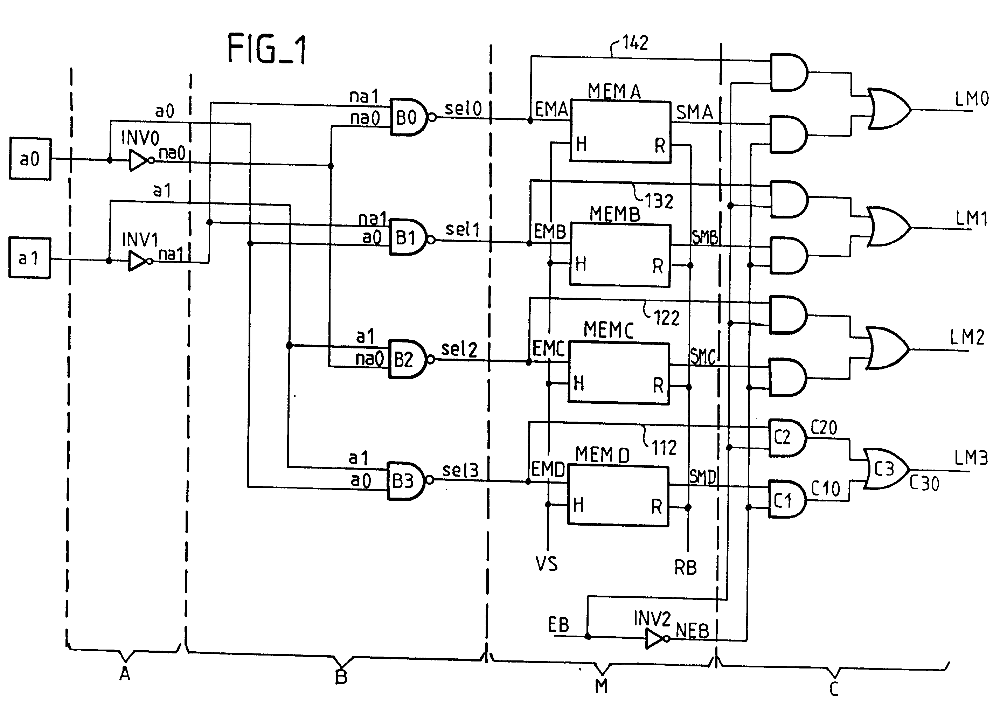

La figure 1 montre un décodeur selon un premier mode de réalisation de l'invention. Pour simplifier la description, on utilise, dans cet exemple, une mémoire à 4 lignes de mots LM0 à LM3, et donc, à 2 bits d'adresse a0 et a1.

Une première logique A du décodeur permet d'obtenir les compléments na0, na1 des bits d'adresse a0 et a1, en utilisant un inverseur INV0, INV1 pour chaque bit d'adresse a0, a1.

Une seconde logique B du décodeur utilise les bits d'adresse a0, a1 et leurs compléments na0, na1, pour décoder l'adresse et sélectionner la ligne de mot correspondante. Dans l'exemple, elle se compose de 4 portes NAND : B0 à B3, qui mettent en oeuvre les 4 équations suivantes :
- décodage de l'adresse 0 (a0 = 0, na0 = 1, a1 = 0, na1=1) :
  sel0 = NAND(na0, na1)
- décodage de l'adresse 1 (a0 = 1, na0 = 0; a1 = 0, na1 = 1) :
  sel1 = NAND(a0, na1)
- décodage de l'adresse 2 (a0 = 0, na0 = 1; a1 = 1, na1 = 0) :
  sel2 = NAND(na0, a1)
- décodage de l'adresse 3 (a0 = 1, na0 = 0; a1 = 1, na1 = 0) :
  sel3 = NAND(a0, a1)

sel0, sel1, sel2 et sel3 sont les sorties respectivement des portes B0, B1, B2, B3 qui correspondent respectivement à la sélection des lignes de mot LM0, LM1, LM2, et LM3. Ce sont des signaux actifs bas : c'est quand le niveau de sel0 est à 0 que la ligne de mot LM0 est dite sélectionnée.

Dans un premier mode de réalisation de l'invention, une logique de mémorisation M est placée après la logique B : un élément de mémorisation est placé en série, à la suite de chacune des sorties des portes NAND de la logique B. Ainsi, les signaux sel0, sel1, sel2 et sel3 sont respectivement une entrée EMA, EMB, EMC et EMD des éléments mémoire MEMA, MEMB, MEMC et MEMD. Chaque élément de mémorisation reçoit par ailleurs une entrée horloge H, fournie dans l'exemple par un signal de validation de sélection VS commun à tous les éléments mémoire MEMA à MEMD et une entrée reset R, fournie dans l'exemple par un signal de reset de bloc RB, commun à tous les éléments mémoire MEMA à MEMD. Chaque élément de mémorisation délivre une sortie, SMA à SMD.

Chaque élément de mémorisation, prenons par exemple MEMA , fonctionne de la manière suivante :
- sur une activation du signal reset R, la sortie SMA passe à l'état 1, quels que soient les états de l'horloge H et de l'entrée EMA;
- quand la sortie SMA est à l'état 1, à chaque signal d'horloge, l'état de la sortie SMA change si l'état de l'entrée EMA est 0, ne change pas si l'état de l'entrée EMA est 1;
- si la sortie SMA est passée à 0, elle reste dans cet état tant qu'il n'y a pas d'activation du signal reset R.

On peut représenter ce fonctionnement par le tableau logique suivant :

3

| H | R | EMA | SMA | SMA |
|---|---|-----|-----|-----|
| X | 1 | X | X | 1 |
| 1 | 0 | 1 | 1 | 1 |
| 1 | 0 | 0 | 1 | 0 |
| 1 | 0 | 0/1 | 0 | 0 |

Un tel fonctionnement est facilement réalisable avec une bascule, comme on le verra dans le deuxième exemple de réalisation de l'invention.

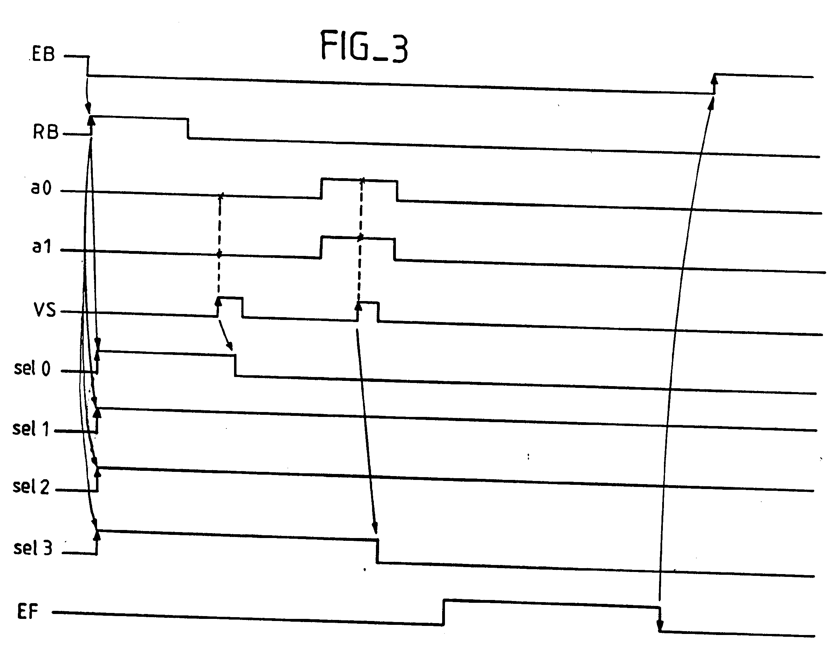

Dans l'invention, les signaux d'horloge H et de reset R sont par exemple fournis par un signal de validation de sélection VS et un signal de reset de bloc RB. Les signaux VS et RB sont par exemple actifs à l'état haut (fig 3). Le signal de validation de sélection VS est activé après chaque positionnement d'une nouvelle adresse pour qu'elle soit mémorisée. En effet (fig 3), quand une adresse a été positionnée, par exemple l'adresse 0, le signal de sélection correspondant, sel0, passe à l'état 0. Si l'élément de mémorisation a été préalablement initialisé (activation de reset), et qu'une activation du signal de validation de sélection est faite (VS passe à l'état actif haut dans l'exemple), alors la sélection sel0 est mémorisée, conformément au fonctionnement ci-dessus décrit (sel0 arrive sur l'entrée EMA). On peut alors positionner une adresse, puis activer le signal de validation de sélection VS, puis positionner une autre adresse etc.. A chaque fois, la sélection est mémorisée. Quand on a positionné toutes les adresses, on peut alors activer un signal de commande d'effacement EF (fig 3) qui va déclencher l'effacement de toutes les lignes de mot dont la sélection a été ainsi mémorisée.

Avantageusement, la mémorisation n'est utilisée que dans un mode particulier d'effacement par bloc : il n'est en effet guère besoin d'utiliser l'élément de mémorisation en lecture par exemple. Aussi un signal de mode d'effacement par bloc EB est-il disponible. C'est par exemple l'activation de ce signal EB qui provoque l'activation du signal de reset de bloc RB (figure 3) pour réinitialiser tous les éléments de mémorisation : les sorties SMA à SMD passent toutes à l'état 1.

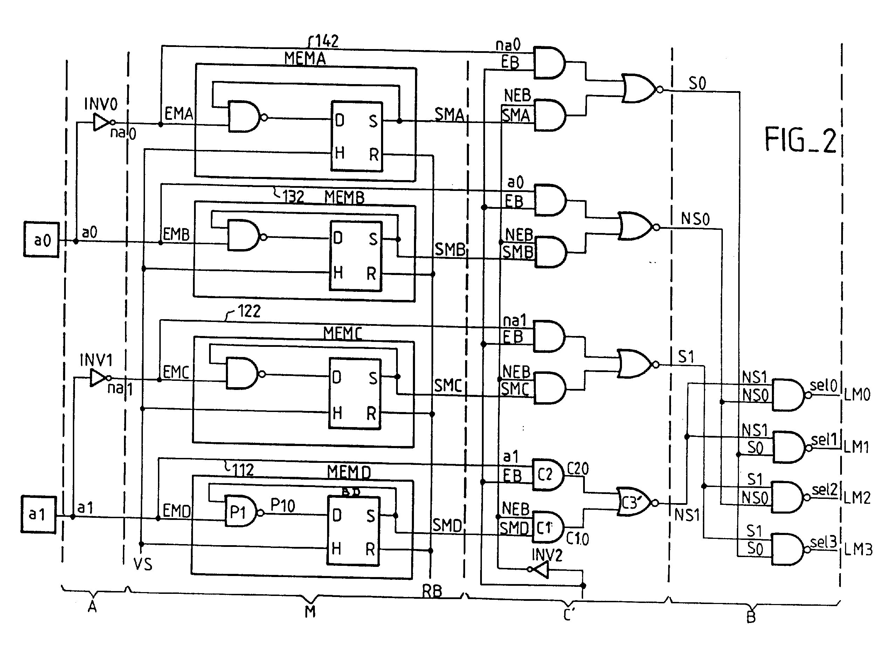

Quand le signal de mode d'effacement par bloc est actif, c'est la sortie de l'élément de mémorisation qui est utilisée; sinon, c'est l'entrée de l'élément de mémorisation. Sur la figure 2, des lignes 112, 122, 132 et 142 sont en effet connectées respectivement aux sorties sel3, sel2, sel1 et sel0 des portes NAND. Une logique C de commutation sélectionne alors, en fonction de l'état du signal de mode d'effacement par bloc EB, soit la sortie de l'élément de mémorisation (SMA, SMB, SMC, SMD), soit son entrée (EMA, EMB, EMC, EMD).

Cette logique C est en quelque sorte un interrupteur qui connecte une ligne de mot, par exemple LM3, soit au signal de sélection correspondant, sel3, hors mode d'effacement par bloc, soit au signal de sélection mémorisé, SMD, en mode d'effacement par bloc.

Cette logique C se compose, dans l'exemple de la figure 1, pour chaque ligne de mot, de 3 portes logiques : si on prend la ligne de mot LM3, on a ainsi les portes logiques C1, C2 et C3. La porte C1 est une porte AND qui a en entrées le signal inversé NEB de mode d'effacement par bloc EB, inversé par l'inverseur INV2 et la sortie de sélection mémorisée SMD. La porte C2 est une porte AND qui a en entrées le signal de mode d'effacement par bloc EB et la sortie de sélection sel3. Les sorties C10 et C20 des portes AND C1 et C2 sont les entrées de la porte C3. La porte C3 est une porte OR, et sa sortie C30 est connectée à la ligne de mot LM3.

Le fonctionnement est alors le suivant : l'état de la sortie C30 de la porte C3 est donnée par l'équation logique suivante :

C30 = sel3.EB + SMD.NEB ,

avec EB actif à l'état bas.

Ainsi :
- en mode d'effacement par bloc, EB=O et NEB=1 : C30 est la recopie de SMD;
- hors du mode d'effacement par bloc, EB=1 et NEB=O : C30 est la recopie de sel3.

Dans le premier mode de réalisation de l'invention décrit, en positionnant successivement les adresses des lignes de mot à effacer, on peut préalablement à l'effacement sélectionner un bloc d'informations constitué de toutes les lignes de mot dont la sélection a été mémorisée, puis effacer simultanément toutes ces lignes de mot, tout ce bloc d'informations. On a une seule opération d'effacement et on gagne donc beaucoup de temps par rapport aux techniques antérieures.

La figure 3 montre le diagramme des temps correspondant à l'effacement par bloc des deux lignes de mot LM0 et LM3 : l'adresse 0 est positionnée (a0=a1=0), le signal de validation de sélection est émis et la mémorisation de la sélection correspondante est effectuée : sel0 qui était au niveau 1 (après le reset de bloc activé par RB=1) passe au niveau 0.

Puis l'adresse 3 est positionnée (a0=a1=1), le signal de validation VS est émis et la mémorisation de la sélection correspondante est effectuée : sel3 qui était au niveau 1 passe au niveau 0.

Un signal d'effacement EF peut être émis (fig 3) : les lignes LM0 et LM3 seront effacées simultanément. Dans l'exemple de la figure 3, le signal EF redevient passif (niveau 0) à la fin de l'effacement et il fait alors remonter le signal de mode d'effacement par bloc EB. Ce fonctionnement n'est qu'un exemple non limitatif de l'invention.

Dans un second mode de réalisation de l'invention, représenté sur la figure 2, on mémorise non plus la sélection d'une ligne de mot, mais les bits d'adresse positionnés et leurs compléments logiques : la logique de la mémorisation est donc ici située entre une logique A d'obtention des compléments des bits d'adresse et une logique B de décodage.

Ce second mode de réalisation trouve son avantage, comme on va le montrer dans la suite, dans la possibilité qu'il offre alors à l'utilisateur de diminuer le nombre d'adresses à positionner pour définir un bloc d'information.

Mais décrivons tout d'abord la figure 2. Une première logique A du décodeur représenté comporte un inverseur INV0, INV1 pour chaque bit d'adresse a0, a1. Ces inverseurs permettent d'obtenir les compléments logiques na0, na1 des bits d'adresse a0, a1.

A la suite de la première logique A, on trouve la logique de mémorisation M déjà décrite, avec un élément de mémoire MEMA, MEMB, MEMC, MEMD pour chaque bit d'adresse et complément, respectivement, na0, a0, na1, a1. Les éléments mémoire fonctionnent comme ceux du premier mode de réalisation; ce fonctionnement ne sera donc pas rappelé ici. Cependant, on a ici précisé une constitution possible d'un tel élément de mémorisation. Prenons par exemple l'élément MEMD : son entrée EMD et sa sortie SMD sont les deux entrées d'une porte AND, P1, dont la sortie P10 est l'entrée D d'une bascule BD. Cette combinaison permet d'obtenir le fonctionnement voulu de l'élément de mémorisation avec une sortie SMD à 1 après reset et une sortie SMD qui change d'état (une seule fois) sur activation du signal d'horloge, si l'entrée EMD vaut 0, ou encore si l'entrée D de la bascule vaut 1.

Ainsi SEMA égal à 0 correspond à la mémorisation de na0=0, SEMB égal 0 correspond à la mémorisation de a0=0, SEMC égal à 0 correspond à la mémorisation de na1=0 et SEMD égal à 0 correspond à la mémorisation de a1=0.

Une logique C' de commutation placée à la suite de la logique de mémorisation permet, de manière analogue à la logique C de commutation du premier mode de réalisation, de ne pas utiliser les sorties mémorisées en dehors du mode d'effacement par bloc. La seule différence avec la logique C, c'est que la porte OR C3 dans la logique C (fig 1) est une porte NOR C3' dans la logique C' (fig 2). Ainsi : les sorties des portes NOR de la logique C', S0, NS0, S1, NS1 sont :

- en mode d'effacement par bloc : les recopies inversées des sorties mémoire SMA, SMB, SMC, SMD. Elles valent donc 1 respectivement si na0=0, a0=0, na1=0 et a1=0 ont été mémorisés.
- en dehors du mode d'effacement par bloc : les recopies inversées respectivement de na0, a0, na1, a1. Elles valent donc 1 respectivement si na0=0, a0=0, na1=0, et a1=0 ont été positionnées.

S0, NS0, S1, NS1 sont les entrées de la logique de décodage B identique à celle du premier mode de réalisation, à base de portes NAND B0, B1, B2, B3. Les équations logiques correspondantes sont donc :

    sel0 = NAND(NS0.NS1)
    sel1 = NAND(S0.NS1)
    sel2 = NAND(NS0.S1)
    sel3 = NAND(S0.S1)

sel0, sel1, sel2, sel3 sont les sorties respectives des portes B0, B1, B2, B3.

Comme dire que a0=0 est équivalent à na0=1, et sachant comme on l'a vu que :

```
S0=1 correspond à na0=0, on a  S0=1 qui correspond à a0=1
NS0=1   "        "      a0=0,   "   NS0=1  "        "      na0=1
S1=1    "        "      na1=0,  "   S1=1   "        "      a1=1
NS1=1   "        "      a1=0    "   NS1=1  "        "      na1=1
```

Les équations logiques s'écrivent donc aussi :

    sel0=NAND(na0.na1)
    sel1=NAND(a0.na1)

sel2=NAND(na0.a1)

sel3=NAND(a0.a1)

qui sont les équations logiques déjà vues dans le premier mode de réalisation.

Si on positionne l'adresse 0 (a0=0; a1=0) et l'adresse 3 (a0=1; a1=1), en mode d'effacement par bloc, on va donc mémoriser :

a0=0

a1=0

na0=0

na1=0

ce qui est équivalent pour le décodage à :

na0=1

na1=1

a0=1

a1=1

Ainsi en positionnant deux adresses, on en sélectionne 4 : non seulement LM0 (a0=0;a1=0) et LM3 (a0=1;a1=1) sont sélectionnées, mais aussi LM1 (a0=1;a1=0) et LM2 (a0=0;a1=1).

Plus généralement, si on a 4 bits d'adresse, pour sélectionner toutes les adresses ayant le bit de poids 2 égal à 0, il suffit de positionner 2 adresses pour que pour tous les autres bits, à la fois le bit et son complément soient mémorisés. Dans l'exemple, pour sélectionner toutes les adresses de type :

XOXX il suffit de positionner :

0000 et 1011 ou

1010 et 0001 ou

0011 et 1000 ...

Il y a plusieurs choix possibles. De cette manière, et en répartissant judicieusement les données dans la mémoire, il est possible de sélectionner un bloc d'information en ne positionnant que 2 adresses au lieu de toutes les adresses des lignes de mot du bloc d'information, comme dans le premier mode de réalisation.

Dans le cas d'un circuit mémoire les signaux de mode d'effacement par bloc EB, de validation de sélection VS, de reset de bloc RB et d'effacement EF pourront être disponibles sur des bornes terminales du boîtier.

Si la mémoire est associée dans un même circuit intégré à un processeur ou un séquenceur d'instructions, ces signaux pourront être pilotés directement par le séquenceur ou le processeur.

## Revendications

1.  Mémoire électriquement programmable et effaçable comportant un décodeur de lignes de mot (LM0, LM1, LM2, LM3), le décodeur étant composé d'une première logique (A) d'obtention des bits d'adresse (a0,a1) des lignes de mot et de leurs compléments logiques (na0, na1) et d'une deuxième logique (B) de décodage des bits d'adresse et de leurs compléments logiques pour sélectionner une ligne de mot et délivrant des signaux de sélection (sel0, sel1, sel2, sel3), caractérisée en ce que le décodeur comporte en outre une logique de mémorisation (M) d'adressage des lignes de mot, permettant une mémorisation de l'adressage de lignes de mot préalable à un effacement simultané des lignes de mot dont l'adressage a été mémorisé.

2.  Mémoire selon la revendication 1, caractérisée en ce que la logique de mémorisation (M) est placée entre la première logique (A) et la seconde logique (B), et qu'elle comporte un élément de mémorisation (MEMA, MEMB, MEMC, MEMD) pour chacun des bits d'adresse et leurs compléments logiques (a0, a1, na0, na1), chaque bit d'adresse et chaque complément étant une entrée (EMA, EMB, EMC, EMD) d'un élément de mémorisation.

3.  Mémoire selon la revendication 1, caractérisée en ce que la logique de mémorisation (M) est placée après la deuxième logique (B) et qu'elle comporte un élément de mémorisation (MEMA,,MEMB, MEMC, MEMD) pour chacun des signaux de sélection (sel0, sel1, sel2, sel3) des lignes de mot , chaque signal de sélection étant une entrée (EMA, EMB, EMC, EMD) de l'élément de mémorisation correspondant.

4.  Mémoire selon la revendication 2 ou 3, caractérisée en ce que l'élément de mémorisation comporte une entrée horloge (H) et une entrée reset (R) et qu'il fonctionne de la manière suivante :
    - sur une activation du signal reset (R), la sortie de l'élément de mémorisation passe à 1, quels que soient les états de l'horloge (H) et de l'entrée de l'élément de mémorisation,
    - quand la sortie de l'élément de mémorisation est à l'état 1, à chaque activation du signal d'horloge (H), l'état de la sortie de l'élément de mémorisation passe à 0 si l'état de l'entrée de l'élément de mémorisation est à 0 et reste à 1 si l'état de l'entrée de l'élément de mémorisation est à 1,
- si la sortie de l'élément de mémorisation est à l'état 0, elle reste dans cet état tant qu'il n'y a pas d'activation du signal reset (R).

5. Mémoire selon la revendication 4, caractérisée en ce que les entrées horloge (H) et reset (R) sont commandées respectivement par un signal de validation (VS) et un signal de reset de bloc (RB) communs à tous les éléments de mémorisation.

6. Mémoire selon la revendication 2 ou 3, caractérisée en ce qu'une logique de commutation (C, C') et un signal de mode d'effacement par bloc (EB) permet de sélectionner, soit l'entrée de l'élément de mémorisation en dehors du mode d'effacement par bloc, soit la sortie de l'élément de mémorisation en mode d'effacement par bloc.

7. Mémoire selon la revendication 5, caractérisée en ce que le signal de reset de bloc (RB) est activé dès l'activation du signal de mode d'effacement par bloc (EB).

8. Mémoire selon la revendication 4 lorsque dépendante de la revendication 2, caractérisée en ce que chaque élément de mémorisation comporte une bascule dont l'entrée (D) est la sortie (P10) d'une porte NAND (P1) ayant en entrées, la sortie (S) de la bascule (D) et l'entrée (EMA, EMB, EMC, EMD) de l'élément de mémorisation, et la sortie (S) de la bascule étant aussi la sortie ‚de l'élément de mémorisation.

9. Procédé d'effacement simultané d'un bloc d'informations dans une mémoire électriquement programmable et effaçable selon la revendication 1, caractérisé en ce qu'il consiste à :
- sélectionner le bloc d'informations en présentant successivement au décodeur de la ligne de mot les adresses de lignes de mot qui définissent le bloc d'informations, en mémorisant à chaque fois les bits d'adresses et leurs compléments ou le signal de sélection de ligne de mot
- et à appliquer une commande d'effacement pour effacer le bloc d'informations ainsi sélectionné.

## Patentansprüche

1. Elektrisch programmierbarer und löschbarer Speicher, mit einem Dekodierer für Wortleitungen (LM0, LM1, LM2, LM3), wobei der Dekodierer versehen ist mit einer ersten Logik (A) zur Gewinnung von Adressenbits (a0, a1) der Wortleitungen und ihrer logischen Komplemente (na0, na1) und einer zweiten Logik (B) zur Dekodierung der Adressenbits und ihrer logischen Komplemente, um eine Wortleitung auszuwählen und Wählsignale (sel0, sel1, sel2, sel3) auszugeben, dadurch gekennzeichnet, daß der Dekodierer außerdem eine Logik zum Speichern (M) der Wortleitungsadressierung umfaßt, mit der die Speicherung der Adressierung der Wortleitungen vor einer gleichzeitigen Löschung der Wortleitungen, deren Adressierung gespeichert worden ist, möglich ist.

2. Speicher gemäß Anspruch 1, dadurch gekennzeichnet, daß die Speicherlogik (M) zwischen der ersten Logik (A) und der zweiten Logik (B) angeordnet ist und daß sie für jedes der Adressenbits und ihrer logischen Komplemente (a0, a1, na0, na1) ein Speicherelement (MEMA, MEMB, MEMC, MEMD) umfaßt, wobei jedes Adressenbit und jedes Komplement ein Eingang (EMA, EMB, EMC, EMD) eines Speicherelementes ist.

3. Speicher gemäß Anspruch 1, dadurch gekennzeichnet, daß die Speicherlogik (M) hinter der zweiten Logik (B) angeordnet ist und daß sie für jedes der Wortleitungs-Wählsignale (sel0, sel1, sel2, sel3) ein Speicherelement (MEMA, MEMB, MEMC, MEMD) umfaßt, wobei jedes Wählsignal ein Eingang (EMA, EMB, EMC, EMD) eines entsprechenden Speicherelementes ist.

4. Speicher gemäß Anspruch 2 oder 3, dadurch gekennzeichnet, daß das Speicherelement einen Takteingang (H) und einen Rücksetzeingang (R) umfaßt und daß es auf die folgende Weise arbeitet:
- aufgrund einer Aktivierung des Rücksetzsignals (R) geht der Ausgang des Speicherelements unabhängig von den Zuständen des Takts (H) und des Eingangs des Speicherelementes in den Zustand 1 über,
- wenn der Ausgang des Speicherelements im Zustand 1 ist, geht bei jeder Aktivierung des Taktsignals (H) der Zustand des Ausgangs des Speicherelements in den Zustand 0 über, wenn der Zustand des

7

Eingangs des Speicherelements 0 ist, während er bei 1 bleibt, wenn der Zustand des Eingangs des Speicherelements 1 ist,
- wenn der Ausgang des Speicherelements im Zustand 0 ist, bleibt er in diesem Zustand, solange das Rücksetzsignal (R) nicht aktiviert wird.

5. Speicher gemäß Anspruch 4, dadurch gekennzeichnet, daß der Takteingang (H) und der Rücksetzeingang (R) von einem Validierungssignal (VS) bzw. von einem Block-Rücksetzsignal (RB) gesteuert werden, die sämtlichen Speicherelementen gemeinsam sind.

6. Speicher gemäß Anspruch 2 oder 3, dadurch gekennzeichnet, daß eine Umschaltlogik (C, C') und ein Signal (EB) für die Betriebsart der blockweisen Löschung entweder außerhalb der Betriebsart der blockweisen Löschung die Wahl des Eingangs des Speicherelements oder in der Betriebsart der blockweisen Löschung die Wahl des Ausgangs des Speicherelements erlauben.

7. Speicher gemäß Anspruch 5, dadurch gekennzeichnet, daß das Block-Rücksetzsignal (RB) ab der Aktivierung des Signals (EB) für die Betriebsart der blockweisen Löschung aktiviert wird.

8. Speicher gemäß Anspruch 4 in Verbindung mit Anspruch 2, dadurch gekennzeichnet, daß jedes Speicherelement eine Kippschaltung umfaßt, deren Eingang (D) der Ausgang (P10) eines NAND-Gatters (P1) ist, welches als Eingänge den Ausgang (S) der Kippschaltung (D) und den Eingang (EMA, EMB, EMC, EMD) des Speicherelements besitzt, wobei der Ausgang (S) der Kippschaltung außerdem der Ausgang des Speicherelementes ist.

9. Verfahren zum gleichzeitigen Löschen eines Blocks von Informationen in einem elektrisch programmierbaren und löschbaren Speicher gemäß Anspruch 1, dadurch gekennzeichnet, daß es umfaßt:
- Wählen des Blocks von Informationen, indem nacheinander in den Dekodierer für Wortleitungen die Adressen derjenigen Wortleitungen eingegeben werden, die den Block von Informationen definieren, indem jedesmal die Adressenbits und ihre Komplemente oder das Wortleitungs-Wählsignal gespeichert werden,
- Eingeben eines Löschungsbefehls zum Löschen des auf diese Weise gewählten Blocks von Informationen.

## Claims

1. An electrically programmable and erasable memory comprising a word line decoder (LM0, LM1, LM2, LM3), the decoder comprising a first logic circuit (A) for obtaining address bits (a0, a1) for the word lines and the logic complements (na0, na1) of those address bits, together with a second logic circuit (B) for decoding the address bits and their logic complements so as to select a word line and provide selection signals (sel0, sel1, sel2, sel3), characterised in that the decoder further includes a memorisation logic circuit (M) for addressing the word lines, so as to enable the addressing of word lines to be memorised prior to a simultaneous erasure of the word lines the addressing of which has been memorised.

2. A memory according to Claim 1, characterised in that the memorisation logic circuit (M) is arranged between the first logic circuit (A) and the second logic circuit (B), and in that it includes a memorisation element (MEMA, MEMB, MEMC, MEMD) for each of the address bits and their logic complements (a0, a1, na0, na1), with each address bit and each complement being an input (EMA, EMB, EMC, EMD) of a memorisation element.

3. A memory according to Claim 1, characterised in that the memorisation logic circuit (M) is arranged after the second logic circuit (B), and in that it includes a memorisation element (MEMA, MEMB, MEMC, MEMD) for each of the word line selection signals (sel0, sel1, sel2, sel3), each selection signal being an input (EMA, EMB, EMC, EMD) of the corresponding memorisation element.

4. A memory according to Claim 2 or Claim 3, characterised in that the memorisation element includes a clock input (H) and a reset input (R), and in that it operates in the following way:
- on activation of the reset signal (R), the output of the memorisation element goes to 1, regardless of the state of the clock (H) and the state of the input of the memorisation element,
- when the output of the memorisation element is in the state 1, on each activation of the clock signal (H), the state of the output of the memorisation element goes to 0 if the state of the input of the memorisation element is 0, and remains at 1 if the state of the input of the memorisation signal is 1,
- if the output of the memorisation signal is in the state 0, it remains in that state so long as the reset signal (R) is not activated.

5. A memory according to Claim 4, characterised in that the clock input (H) and the reset input (R) are controlled respectively by a validation signal (VS) and a block reset signal (RB) common to all of the memorisation elements.

6. A memory according to Claim 2 or Claim 3, characterised in that a switch-over logic circuit (C, C') and a block erasure mode signal (EB) provide selection of either the input of the memorisation signal when outside the block erasure mode, or the output of the memorisation element when in the block erasure mode.

7. A memory according to Claim 5, characterised in that the block reset signal (RB) is activated on activation of the block erasure mode signal (EB).

8. A memory according to Claim 4 when dependent on Claim 2, characterised in that each memorisation element includes a flip-flop, the input (D) of which is the output (P10) of a NAND gate (P1) having as inputs the output (S) of the flip-flop (D) and the input (EMA, EMB, EMC, EMD) of the memorisation element, the output (S) of the flip-flop being also the output of the memorisation element.

9. A method of simultaneously erasing a block of data in an electrically programmable and erasible memory in accordance with Claim 1, characterised in that it consists in:
- selecting the block of data by presenting successively to the word line decoder the word line addresses that define the block of data, by memorising, each time, the address bits and their complements or the word line selection signal
- and applying an erasure command so as to erase the block of data thus selected.

FIG_1

EP 0 447 276 B1

FIG_2

EP 0 447 276 B1

# FIG_3

EB

RB

a0

a1

VS

sel 0

sel 1

sel 2

sel 3

EF

EP 0 447 276 B1

FIG_4